# EUROPEAN PATENT SPECIFICATION

(11) **EP 3 511 786 B1**
(45) Date of publication and mention of the grant of the patent: **13.01.2021**
(21) Application number: 18200199.0
(22) Date of filing: 12.10.2018
(51) Int. Cl.: G05B 19/05, H03M 1/12

(54) **SIGNAL PROCESSING DEVICE AND CONTROL METHOD OF SIGNAL PROCESSING DEVICE**
SIGNALVERARBEITUNGSVORRICHTUNG UND STEUERUNGSVERFAHREN EINER SIGNALVERARBEITUNGSVORRICHTUNG
DISPOSITIF DE TRAITEMENT DE SIGNAL ET PROCÉDÉ DE COMMANDE DE DISPOSITIF DE TRAITEMENT DE SIGNAL

(30) Priority: 10.01.2018 JP 2018001761
(43) Date of publication of application: 17.07.2019
(73) Proprietor: Omron Corporation, Kyoto-shi, Kyoto 600-8530 (JP)
(72) Inventor: YOSHIOKA, Ryohei, Kyoto-shi, Kyoto 600-8530 (JP)
(74) Representative: 2K Patentanwälte Blasberg Kewitz & Reichel

(56) References cited:
- US-A- 4 596 977
- US-A- 4 908 623

## Description

### BACKGROUND OF THE INVENTION

### Technical Field

The present invention relates to a signal processing device and the like, in particular, to a signal processing device which processes a signal from a sensor and delivers the signal to a control device.

### Related Art

A signal processing device is known which acquires, from a sensor mounted on an industrial machine, such as a measuring device, the physical quantity detected by the sensor, processes the detected signal that is acquired, and delivers the signal to a control device which controls the industrial machine. In such a signal processing device, an analog signal acquired from the sensor is converted into a digital signal by an A/D converter and delivered to the control device.

For example, in patent literature 1 (Japanese Laid-Open No. 2017-134769 (published on August 3, 2017)), a signal control device is disclosed which acquires a signal from a sensor in a data acquisition period that is shorter than a delivery cycle to a control device, thereby avoiding the delay in noise elimination from the signal and delivering the time series data related to the signal after noise elimination to the control device without being delayed Document US4908623 discloses dual slope analog-to-digital converter that is able to identify an out of range condition.

### SUMMARY

Here, for A/D converters with equal performance, in a case that a division number of an analog input signal is set high, the input conversion range of the analog input signal is limited. Therefore, compared with a case in which the division number of the analog input signal is set low, in the case that the division number of the analog input signal is set high, the value of the analog input signal easily turns into such a state as described below. For example, the value of the analog input signal is in an over-range state in which the value exceeds the input conversion range of the A/D converter, or the value of the analog input signal is in an under-range state in which the value falls below the input conversion range. The detail is described below.

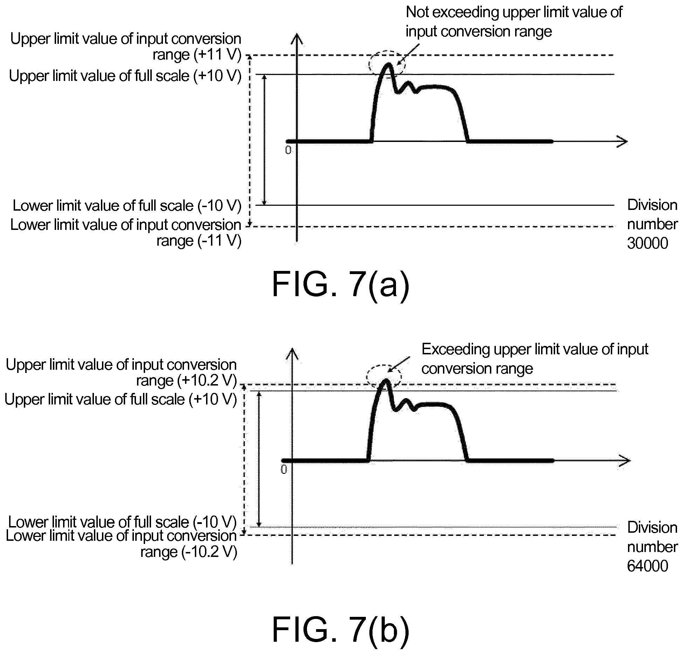

FIG. 7(a) and 7(b) are drawings showing an example in which an analog input signal turns into an over-range or under-range state in an A/D converter having a resolution of 16 Bit or 18 Bit. FIG. 7(a) shows an example of the state of the analog input signal when a division number of the analog input signal is set to 30000 under full-scale upper and lower limit values (+10 V, -10 V). Besides, FIG. 7(b) shows an example of the state of the analog input signal when the division number of the analog input signal is set to 64000 under the full-scale upper and lower limit values (+10 V, -10 V). As shown in FIG. 7(a), when the division number is set to as low as 30000, the input conversion range is set to 105% and -5% of the full-scale upper and lower limit values. That is, the upper limit value of the input conversion range is +11 V, and the lower limit value is -11 V. Therefore, as long as the value of the analog input signal does not reach +11 V or not fall below -11 V, the analog input signal does not turn to an over-range or under-range state. In contrast, as shown in FIG. 7(b), when the division number is set to as high as 64000, the input conversion range is necessarily limited to 101% and -1% of the full-scale upper and lower limit values. That is, the upper limit value of the input conversion range is +10.2 V, and the lower limit value is -10.2 V. Therefore, compared with the case that the division number is set to as low as 30000, the frequency at which the analog input signal turns into an over-range or under-range state increases. Besides, in FIG. 7(a) and FIG. 7(b), the time series data of the analog input signal when overshoot occurs is shown. As shown in FIG. 7(a), when the upper limit value of the input conversion range is +11 V, the value of the analog input signal does not exceed the upper limit value. On the other hand, as shown in FIG. 7(b), when the upper limit value of the input conversion range is +10.2 V, the value of the analog input signal exceeds the upper limit value. That is, by setting a high division number, the input conversion range becomes narrow; as a result, the analog input signal easily turns over-range or under-range.

For example, when the analog input signal turns into an over-range or under-range state, in a configuration in which a notification showing the abnormality of the analog signal is given, such problems as described below come up. That is, when the division number is set high, the notification showing the abnormality of the analog signal is frequently given. For example, the over-range or under-range state of the analog input signal caused by overshoot or undershoot is not necessarily a case in which an abnormal state occurs. However, if the notification showing the abnormality of the analog signal is frequently given even in such a case, problems such a decrease in the operation rate are caused.

Such related art as shown in the above-mentioned patent literature 1 is a technology of eliminating the noise in the signal, other than a technology intending to suppress an unnecessary "notification that shows an abnormality". One aspect of the present invention aims to realize a signal processing device which can suppress an unnecessary notification in the notification showing an abnormality of the analog signal.

In order to solve the problems, the signal processing device of one aspect of the present invention is a signal processing device that processes an analog input signal from a sensor and delivers the signal to a control device, and includes: a signal state determination part, which determines, for the analog input signal, whether an over-range or under-range state lasts longer than a predetermined time; and a notification part, which notifies the control device that an over-range or under-range state occurs when the signal state determination part determines that the state lasts longer than the predetermined time.

Besides, a control method of the signal processing device of one aspect of the present invention is a control method of a signal processing device which processes an analog input signal from a sensor and delivers the signal to a control device, and includes: a signal state determination step, which determines, for the analog input signal, whether an over-range or under-range state lasts longer than a predetermined time; and a notification step, which notifies the control device that the over-range or under-range state occurs when it is determined in the signal state determination step that the state lasts longer than the predetermined time.

According to the above configuration, even if the analog input signal turns into an over-range or under-range state (abnormal state), when the state does not last for a predetermined time, the notification is not given which shows the over-range or under-range state of the analog input signal. For example, when the analog input signal turns into an abnormal state because of overshoot or undershoot, the cause of the state is not the failure in the sensor and so on. Therefore, the notification to the effect that the analog input signal is in an abnormal state is unnecessary. Besides, the duration of the abnormal state of the analog input signal caused by overshoot or undershoot is limited. Therefore, by appropriately setting the predetermined time, the notification of abnormal state caused by overshoot or undershoot can be suppressed.

The signal processing device of one aspect of the present invention may also include a reception part which acquires a user operation that sets the predetermined time; and a determination condition setting part which sets the predetermined time in accordance with the user operation.

According to the above configuration, for the analog input signal, when the over-range or under-range state lasts longer than the predetermined time desired by the user, the control device can be notified that the state occurs.

The signal processing device of one aspect of the present invention may also include a display instruction part which causes time series data of the analog input signal to be displayed on an external machine. According to the above-mentioned configuration, the time series data of the analog input signal can be shown to the user.

The signal processing device of one aspect of the present invention may further include a plurality of channels for connection to each of a plurality of the sensors, and the time series data may be the time series data of one of the analog input signals input by one of the channels, or be the time series data of a plurality of the analog input signals input by a plurality of different channels.

According to the above-mentioned configuration, the time series data of one analog input signal input by one channel, or the time series data of a plurality of analog input signals input by a plurality of different channels can be shown to the user. Besides, by displaying the time series data of a plurality of analog input signals input by a plurality of different channels, the user can compare the time series data of the analog input signals input by each channel.

In the signal processing device of one aspect of the present invention, the predetermined time may be the integer multiple of a sampling period of the analog input signals by the signal processing device.

According to the above-mentioned configuration, for the analog input signals sampled continuously by the signal processing device for predetermined times, when the over-range or under-range state lasts, the occurrence of the state can be notified.

In the signal processing device of one aspect of the present invention, the control device may be a master device in a master-slave control system, and the signal processing device may be a slave device connected to the master device via a network.

According to the above-mentioned configuration, the signal processing device can be applied in a master-slave control system.

According to one aspect of the present invention, unnecessary notification can be suppressed in the notification showing abnormality of the analog signal.

### BRIEF DESCRIPTION OF THE DRAWINGS

FIG. 1 is a block diagram showing an example of a main part configuration of a signal processing device in an embodiment of the present invention.
(a) of FIG. 2 and (b) of FIG.2 are drawings showing an example of a processing performed to an analog input signal by a signal processing device of an embodiment of the present invention.
FIG. 3 is a drawing showing an overview of a control system of an embodiment of the present invention.
FIG. 4 is a flowchart showing an example of a processing flow of a signal processing device in an embodiment of the present invention.
FIG. 5 is a flowchart showing another example of a processing flow of a signal processing device in an embodiment of the present invention.
FIG. 6 is a drawing showing an example of setting a predetermined time used for the determination performed by a signal state determination part of an embodiment of the present invention.
FIG. 7(a) and 7(b) are drawings showing an example in which an analog input signal turns into an over-range or under-range state.

### DESCRIPTION OF THE EMBODIMENTS

### [embodiment 1]

Next, an embodiment of one aspect of the present invention (also referred to as "the embodiment" hereinafter) is described based on the drawings.

### § 1 Application example

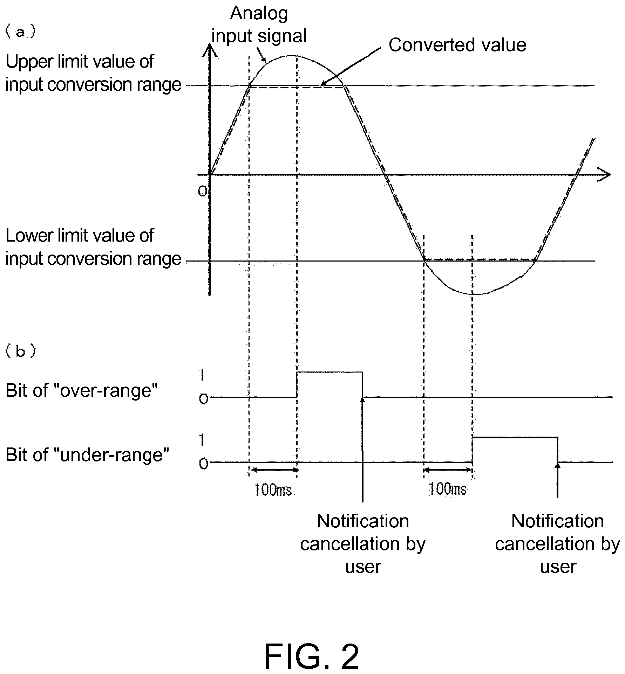

A signal processing device 10 determines, for an analog input signal, whether an over-range or under-range state lasts longer than a predetermined time. When the state lasts longer than a predetermined time, the signal processing device 10 notifies a controller (control device) 40 that an over-range or under-range state occurs in the analog input signal.
(a) of FIG. 2 and (b) of FIG.2 are drawings showing an example of a processing performed to the analog input signal by the signal processing device 10 of the embodiment. Specifically, (a) of FIG. 2 is a drawing showing an example of a processing in which the signal processing device 10 converts the analog input signal into a digital signal. In (a) of FIG. 2, the value of the analog input signal (analog input signal) is represented by a solid line, and the value of the digital signal (converted value) is represented a dotted line. As shown in (a) of FIG. 2, when the value of the analog input signal is within the input conversion range, the signal processing device 10 directly converts the value of the analog input signal into a digital signal. On the other hand, when the value of the analog input signal is out of the input conversion range, the signal processing device 10 converts the value of the analog input signal into a digital signal with the value of the analog input signal as the upper limit value (or the lower limit value) of the input conversion range.
(b) of FIG.2 is a drawing showing an example of the generation of the signal sent by the signal processing device 10 to the controller 40 (the signal which notifies the controller 40 that an over-range or under-range state occurs). The signal indicates the state of the analog input signal by values. As shown in (b) of FIG. 2, the signal indicating the value of 1 indicates that analog input signal is in an over-range or under-range state (abnormal state). Besides, the signal indicating the value of 0 indicates that the analog input signal is in a normal state. In the example shown in (b) of FIG. 2, when the over-range or under-range state lasts longer than the predetermined time (100 ms in the example shown in (b) of FIG. 2), the signal processing device 10 generates the signal which indicates the value of 1. Upon receiving the signal which indicates the value of 1 (the signal which indicates that the analog input signal is in an abnormal state), the controller 40 causes the images showing that the analog input signal is in an abnormal state to be displayed on a display input device 50. Besides, the signal processing device 10 may be configured to accept an input operation of the user which cancels the normality notification through an external machine (such as a support device 60 described below), and restore the value of the signal to 0.

According to the above-mentioned configuration, even if the analog input signal turns into an over-range or under-range state, when the state does not last longer than 100 ms, the notification that the analog input signal is in an abnormal state is not performed. For example, when the analog input signal is in an over-range or under-range state (abnormal state) because of overshoot or undershoot, the cause of the state is not the failure in the sensor and so on. Therefore, the notification to the effect that the analog input signal is in an abnormal state is unnecessary. Besides, the duration of the abnormal state of the analog input signal caused by overshoot or undershoot is limited. Therefore, by appropriately setting the predetermined time, the notification of abnormal state of the analog input signal caused by overshoot or undershoot can be suppressed.

Besides, the signal processing device 10 may be configured to receive a plurality of analog input signals from a plurality of sensors, and may perform the abnormality notification processing to each analog input signal.

### §2 Configuration example

### (Control system 1)

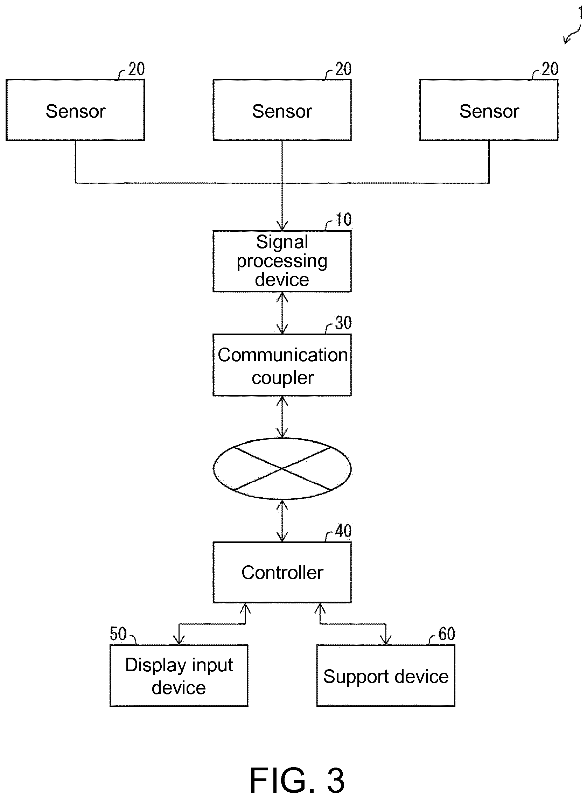

FIG. 3 is a drawing showing an overview of a control system 1 of the embodiment. As shown in FIG. 3, the control system 1 includes a plurality of sensors 20, a signal processing device 10, a communication coupler 30, a controller 40, a display input device 50 and a support device 60.

For example, the controller 40 is a master device, and the signal processing device 10 is a slave device connected to the master device via a high-order bus, namely a high-order communication network. In other words, the control system 1 may be a master-slave control system which includes the controller 40 serving as the master device, and more than one signal processing devices 10 connected to the master device via the network and serving as slave devices. While the controller 40 is called a "master device" in the sense of management of data transmission via the high-order communication network, the signal processing device 10 is called a "slave device".

### (Signal processing device 10)

As shown in FIG. 3, the signal processing device 10 is a relay device which relays data between a high-order network including the controller 40 and the like and the sensor 2. In the embodiment, the signal processing device 10 is an A/D converter which converts the analog signal to a digital signal.

### (Communication coupler 30)

The communication coupler 30 is a relay device which relays the communication between the high-order network and the signal processing device 10. The communication coupler 30 relays the communication between the machine included in the high-order network and the signal processing device 10.

### (Sensor 20)

The sensor 20 detects the physical quantity (state value) of a control target (not shown), and outputs the signal corresponding to the detected physical quantity (for example, an analog signal) to the signal processing device 10. The state value of the control target detected by the sensor 20 may be any physical quantity such as weight, pressure and so on. As shown in FIG. 3, the sensor 20 is a device connected to the signal processing device 10 for communication and becomes the control target of the controller 40.

### (Controller 40)

The controller 40 is a control device which integrally controls the whole control system 1, for example, a PLC (Programmable Logic Controller). The controller 40 acts as the master device of the signal processing device 10 in the control system 1. As shown in FIG. 3, the support device 60, the display input device 50 and so on may be connected to the controller 40 via a connection cable and the like.

### (Support device 60)

The support device 60 is a device connected to the control system 1 to be used for various settings in the control system 1 such as the operation setting of the sensor 20 and the signal processing device 10. The support device 60 can be connected to the control system 1 through the controller 40. The support device 60 may be an information processing device such as a personal computer or a portable information device such as a notebook computer. Moreover, the support device 60 may also connected to the signal processing device 10 via the communication coupler 30 and perform various settings.

### (Display input device 50)

The display input device 50 is, for example, a touch-panel type display input device. The user of the control system 1 can operate the controller 40 via the display input device 50, or confirm the operation state of the control system 1 with the display input device 50.

### (Configuration of signal processing device 10)

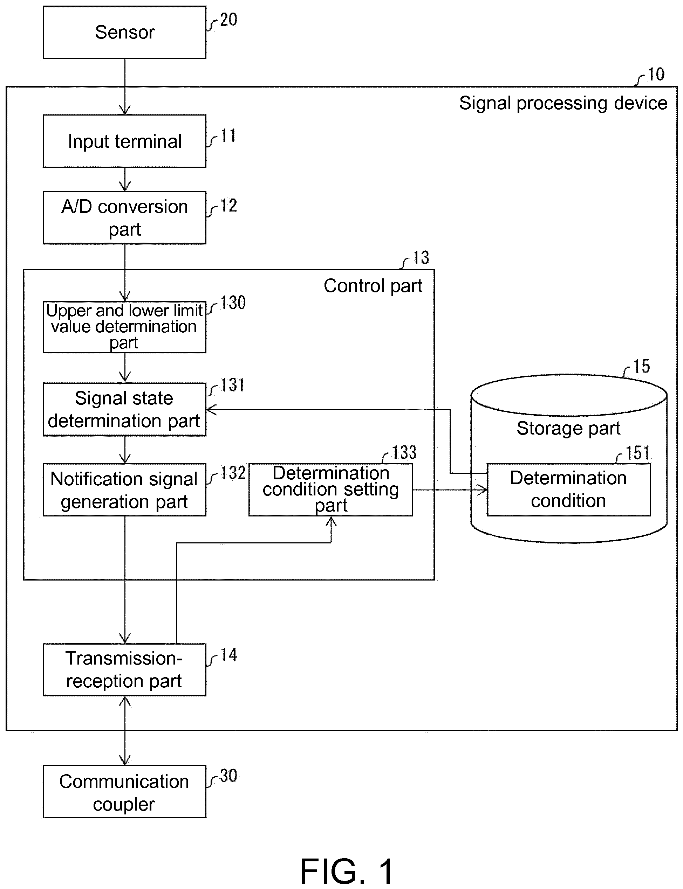

FIG. 1 is a block diagram showing an example of the main part configuration of the signal processing device 10 in the embodiment. As described above, the signal processing device 10 is an A/D converter which converts the input analog signal into a digital signal. As shown in FIG. 1, the signal processing device 10 includes an input terminal 11, an A/D conversion part 12, a control part 13, a transmission-reception part (a notification part, a reception part)14 and a storage part 15.

### (Input terminal 11)

The input terminal 11 accepts the input of a signal from an external machine. In the embodiment, the input terminal 11 accepts the input of an analog signal from the sensor 20 in particular. Besides, the signal processing device 10 may also accept the input of an analog signal from each of a plurality of the sensors 20 by each of a plurality of channels. In this configuration, the signal processing device 10 may include a plurality of input terminals 11 corresponding to the plurality of channels.

### (A/D conversion part 12)

The A/D conversion part 12 converts the analog signal output by the sensor 20 into a digital signal cyclically (at a sampling cycle).

Specifically, when the value of the analog signal (analog input signal) output by the sensor 20 is within the input conversion range, the A/D conversion part 12 directly converts the value of the analog input signal into a digital signal. On the other hand, when the value of the analog input signal is out of the input conversion range, the A/D conversion part 12 converts the value of the analog input signal into a digital signal with the value of the analog input signal as the upper limit value (or the lower limit value) of the input conversion range.

The A/D conversion part 12 transmits the digital signal to the control part 13. In the embodiment, the digital signal is transmitted to a signal state determination part 131 in particular.

### (Control part 13)

The control part 13 includes a CPU (Central Processing Unit), a RAM (Random Access Memory), a ROM (Read Only Memory) and the like, and controls each configuration element according to the information processing. The control part 13 includes an upper and lower limit value determination part 130, a signal state determination part 131, a notification signal generation part (a notification part, a display instruction part) 132 and a determination condition setting part 133.

Besides, the control part 13 may conduct a filter processing to eliminate the noise of the digital signal. The control part 13 may transmits the digital signal to which the filter processing is conducted to the controller 40 via the communication coupler 30.

### (Upper and lower limit value determination part 130)

The upper and lower limit value determination part 130 determines, in each sampling cycle, whether the value of the digital signal received from the A/D conversion part 12 is the upper limit value or lower limit value of the input conversion range, and notifies, in each sampling cycle for example, the signal state determination part 131 of the determination result. The upper and lower limit value determination part 130 may transmit the received digital signal to the signal state determination part 131 only when the value of the received digital signal is the upper limit value or lower limit value of the input conversion range.

Besides, the upper and lower limit value determination part 130 may cause the time series data of the analog input signal to be displayed on an external machine.

For example, the upper and lower limit value determination part 130 determines whether the value of the digital signal received from the A/D conversion part 12 is above or below a predetermined value. Here, the predetermined value is a value set within the input conversion range, and is a value used to determine whether the value of the analog input signal is close to the upper limit value or lower limit value of the input conversion range. For example, the predetermined value may be set to two values, one of which is used to determine whether the value of the analog input signal is close to the upper limit value of the input conversion range, and the other of which is used to determine whether the value of the analog input signal is close to the lower limit value of the input conversion range. The upper and lower limit value determination part 130 may notify, in accordance with the determination result, the notification signal generation part 132 that the value of the digital signal is above or below the predetermined value (close to the upper limit value or lower limit value of the input conversion range).

According to the above-mentioned configuration, the time series data of the analog input signal can be displayed to the user. Moreover, the display input device 50 may also be a configuration which accepts an instruction of the time series data of the analog input signal from the user and displays the time series data.

### (Signal state determination part 131)

The signal state determination part 131 determines, for the analog input signal, whether an over-range or under-range state lasts longer than a predetermined time.

Specifically, the signal state determination part 131 determines whether the receiving of the digital signal indicating the upper limit value or lower limit value of the input conversion range lasts longer than a predetermined time. That is, the signal state determination part 131 determines whether the digital signal in each sampling cycle is continuously determined by the upper and lower limit value determination part 130 to be the upper limit value or lower limit value for longer than a predetermined time (for example, the duration of predetermined integer multiple of the sampling cycle). When the receiving of the digital signal indicating the upper limit value or lower limit value of the input conversion range lasts longer than the predetermined time, the signal state determination part 131 notifies the notification signal generation part 132 that the analog input signal is in an over-range or under-range state (abnormal state). The signal state determination part 131 may also perform the determination with reference to, for example, determination condition 151 stored in the storage part 15 which indicates the predetermined time.

When "n times of the sampling cycle ≥ the predetermined time", the signal state determination part 131 determines that the determination result of the upper and lower limit value determination part 130 in each sampling cycle "is the upper limit value or lower limit value" continuously form more than n times. Moreover, in the description below, "n" is "an integer of 1 or more".

When the determination result of the upper and lower limit value determination part 130 in each sampling cycle is continuously "the upper limit value or lower limit value" for more than n times, the signal state determination part 131 determines that an over-range or under-range state occurs. Then, the signal state determination part 131 notifies the notification signal generation part 132 of the determination result. In contrast, when the determination result of the upper and lower limit value determination part 130 is not continuously "the upper limit value or lower limit value" for more than n times, the signal state determination part 131 determines that an over-range or under-range state does not occur.

For example, in a case of "sampling cycle = 50 ms", and "twice of sampling cycle=100 ms ≥ predetermined time > 50 ms = one time of sampling cycle", the signal state determination part 131 conducts the following processing. That is, the signal state determination part 131 determines whether "the determination result of the upper and lower limit value determination part 130 in each sampling cycle is continuously the upper limit value or lower limit value for more than twice".

When it is determined that "the determination result of the upper and lower limit value determination part 130 in each sampling cycle is continuously 'the upper limit value or lower limit value' for more than twice", the signal state determination part 131 determines that an over-range or under-range state occurs. The signal state determination part 131 determines, when the determination result of the upper and lower limit value determination part 130 in the n-th cycle is "the upper limit value or lower limit value", and the determination result of the upper and lower limit value determination part 130 in the n+1-th cycle is also "the upper limit value or lower limit value", that an over-range or under-range state occurs.

In contrast, when it is determined that "even if one of the determination result of the upper and lower limit value determination part 130 in each sampling cycle is 'the upper limit value or lower limit value', the determination result of the upper and lower limit value determination part 130 is not continuously 'the upper limit value or lower limit value"', the signal state determination part 131 determines that an over-range or under-range state does not occur. That is, even when the determination result of the upper and lower limit value determination part 130 in the n-th cycle is "the upper limit value or lower limit value", if the determination result of the upper and lower limit value determination part 130 in the n+1-th cycle is not "the upper limit value or lower limit value", the signal state determination part 131 determines that an over-range or under-range state does not occur.

Besides, the predetermined time may be set to integer multiple of the sampling period of the analog input signal in the A/D conversion part 12.

According to the above-mentioned configuration, when an over-range or under-range state lasts for analog input signals continuously sampled by the A/D conversion part 12 for predetermined times, it can be determined that the state occurs.

Besides, the signal processing device 10 may further include a plurality of channels for the connection to each of the plurality of sensors 20. The above-mentioned time series data may be the time series data of one analog input signal input by one channel or the time series data of a plurality of analog input signals input by a plurality of different channels.

According to the above-mentioned configuration, the time series data of one analog input signal input by one channel or the time series data of a plurality of analog input signals input by a plurality of different channels can be displayed to the user. Besides, by displaying the time series data of a plurality of analog input signals input by a plurality of different channels, the user can compare the time series data of the analog input signals input by each channel with each other.

### (Notification signal generation part 132)

In accordance with the determination result of the signal state determination part 131, the notification signal generation part 132 notifies the controller 40 that an over-range or under-range state occurs in the analog input signal.

Specifically, the notification signal generation part 132 generates a signal which indicates the state of the analog input signal. The notification signal generation part 132 generates, in accordance with an instruction of generating a signal which indicates that the analog input signal of the signal state determination part 131 is in an abnormal state, a signal which indicates that the analog input signal is in an abnormal state. Moreover, when such an instruction is not received from the signal state determination part 131, the notification signal generation part 132 may generates a signal which indicates that the analog input signal is in a normal state. Detailed example of the signal which indicates the state of the analog input signal is described in the above-mentioned "§1 Application example", therefore repeated description is omitted here. The notification signal generation part 132 transmits the generated signal to the transmission-reception part 14 and instructs a transmission to the controller 40.

Besides, the notification signal generation part 132 may be configured so that once the signal indicating that the analog input signal is in an abnormal state is generated, the signal generation goes on until an input operation of notification cancellation from the user is accepted. For example, the notification signal generation part 132 may accept the input operation of notification cancellation of the user from the display input device 50 via the controller 40 and the transmission-reception part 14.

Besides, when the upper and lower limit value determination part 130 determines that the value of the analog input signal is close to the upper limit value or lower limit value of the input conversion range, the notification signal generation part 132 may also perform the following processing. The notification signal generation part 132 generates a signal which instructs the controller 40 to display the time series data of the analog input signal through the transmission-reception part 14 and the communication coupler 30.

The notification signal generation part 132 transmits the generated signal to the transmission-reception part 14 and instructs a transmission to the controller 40. The controller 40 may instruct the display input device 50 and so on to display upon receiving the instruction.

Besides, the display of the time series data of the analog input signal may also be conducted when the controller 40 accepts an operation of the user instructing the display via the display input device 50 and so on.

### (Determination condition setting part 133)

The determination condition setting part 133 sets the predetermined time according to the user operation. Specifically, the determination condition setting part 133 accepts, from the support device 60 and via the transmission-reception part 14, the user operation on the setting of the predetermined time indicated by the determination condition 151. The determination condition setting part 133 sets the predetermined time indicated by the determination condition 151 based on this operation.

According to the above-mentioned configuration, for the analog input signal, when an over-range or under-range state lasts longer than the predetermined time desired by the user, the controller 40 can be notified of the occurrence of the state. Besides, when the signal processing device 10 is configured to process a plurality of analog input signals, it may be configured so that the user can set the predetermined time indicated by the determination condition 151 for each analog input signal. For example, when the display input device 50 is configured to display the time series data (for example, waveform data) of a plurality of analog input signals, the signal processing device 10 may be configured as follows. The signal processing device 10 accepts the input data from the user regarding the setting (change) of the predetermined time indicated by the determination condition 151 for each analog input signal, and sets the predetermined time for each analog input signal.

### (Transmission-reception part 14)

The transmission-reception part 14 receives the signal from the notification signal generation part 132 and transmits the signal to the communication coupler 30. Besides, the transmission-reception part 14 receives, from the communication coupler 30, the operation input of the user related to the setting of the predetermined time indicated by the determination condition 151, and transmits to the determination condition setting part 133.

Besides, the transmission-reception part 14 transmits the digital signal converted by the A/D conversion part 12 to the communication coupler 30. The communication coupler 30 cyclically delivers the signal received from the signal processing device 10 (the transmission-reception part 14) to the controller 40 (control device) in a predetermined delivery cycle.

Besides, the transmission-reception part 14 acquires, from the support device 60 and via the communication coupler 30 and the controller 40, the user operation which sets the predetermined time indicated by the determination condition 151. The transmission-reception part 14 transmits the input data to the determination condition setting part 133.

### (Storage part 15)

The storage part 15 is, for example, an auxiliary storage device such as a solid state drive, and stores the above-mentioned determination condition 151 and so on.

### §3 Operation example

### (Example of processing flow of signal processing device 10: abnormality notification determination processing of analog input signal)

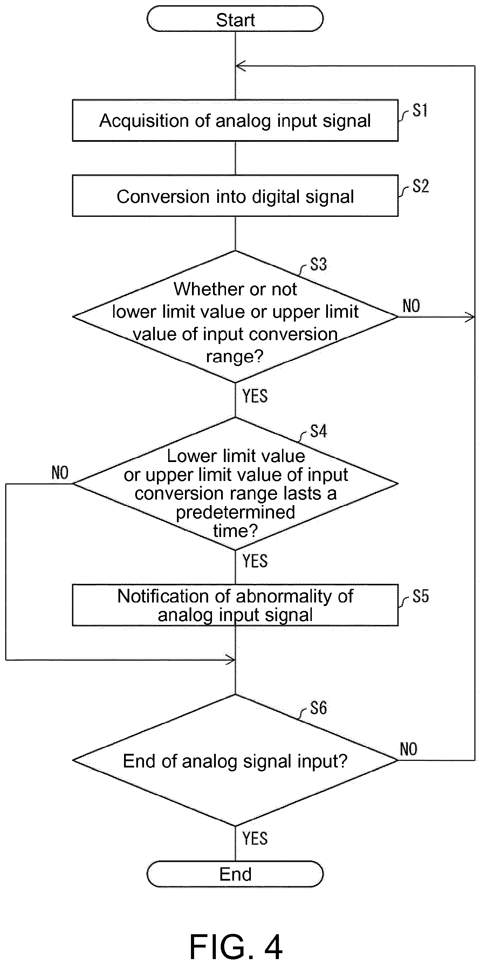

FIG. 4 is a flowchart showing an example of the flow of abnormality notification determination processing of the analog input signal of the signal processing device 10. An example of the processing flow of the signal processing device 10 is described using FIG. 4. The A/D conversion part 12 cyclically samples (acquires) the analog input signal (SI), and converts the analog input signal into a digital signal (S2). Next, the upper and lower limit value determination part 130 determines, in each sampling cycle, whether the value of the converted digital signal is the upper limit value or lower limit value of the input conversion range (S3). When the value of the converted digital signal is the upper limit value or lower limit value of the input conversion range ("YES" in S3), the processing proceeds to S4 described below. The signal state determination part 131 determines, for the converted digital signal, whether the lower limit value or upper limit value of the input conversion range lasts for the predetermined time (S4: signal state determination step). That is, for the number n which satisfies "n times of sampling cycle ≥ predetermined time", the signal state determination part 131 determines whether the determination result of the upper and lower limit value determination part 130 in each sampling cycle is continuously "the upper limit value or lower limit value" for more than n times. When the value of the digital signal lasts for the predetermined time in the form of the lower limit value or the upper limit value ("YES" in S4), the notification signal generation part 132 notifies the controller 40 of the abnormality of the analog signal by transmitting a signal which indicates the state of the analog input signal (S5: notification step). Next, when the input of the analog signal is ended ("YES" in S6), the processing is ended. Moreover, when the input of the analog signal is not ended ("NO" in S6), the processing returns to S1. Besides, when the lower limit value or upper limit value does not last for the predetermined time ("NO" in S4), the processing proceeds to S6. Besides, when the value of the converted digital signal is not the upper limit value or lower limit value of the input conversion range ("NO" in S3), the processing also proceeds to S6.

### (Example of processing flow of signal processing device 10: determination condition setting processing)

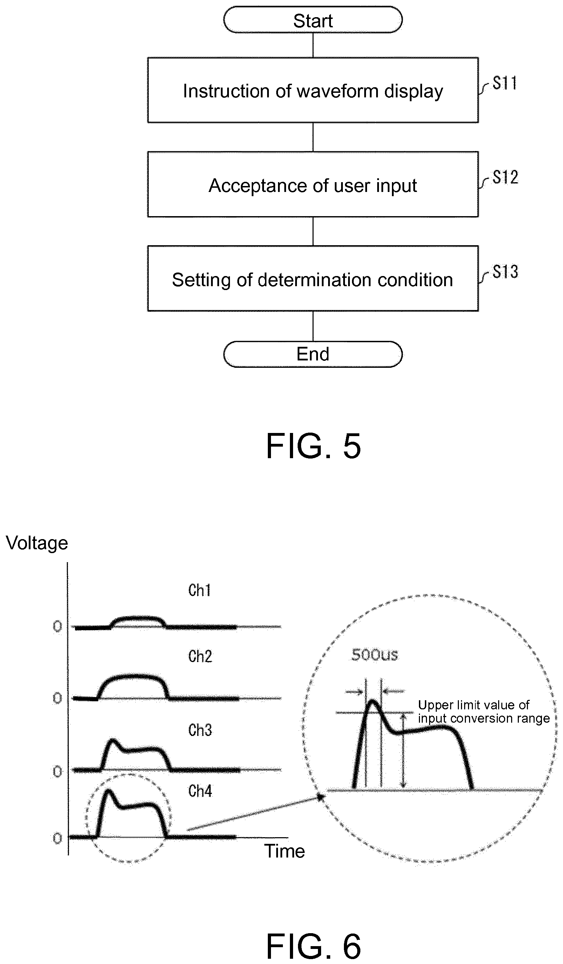

FIG. 5 is a flowchart showing an example of the condition setting processing flow of the abnormality notification determination of the analog input signal of the signal processing device 10. An example of the processing flow of the signal processing device 10 is described using FIG. 5. The notification signal generation part 132 instructs the controller 40 to display the time series data of the analog input signal (S11). Next, the transmission-reception part 14 receives the input data of the user related to the predetermined time indicated by the determination condition 151 (S12). Next, the determination condition setting part 133 changes the predetermined time indicated by the determination condition 151 based on the input data (sets the determination condition) (S13). Then, the processing is ended.

FIG. 6 is a drawing showing an example of the setting of the predetermined time used for the determination performed by the signal state determination part 131. The graph in FIG. 6 represents the time series data of a plurality of analog input signals. For example, the display input device 50 may display the graph shown in FIG. 6 as the time series data of the analog input signal. In the graph shown in FIG. 6, channel numbers (chl-ch4) corresponding to each analog input signal are associated. The waveform in the circle of the dotted line in FIG. 6 is the time series data of the analog input signal of ch4. More specifically, the behavior of the value of analog input signal caused by overshoot is shown. As shown in FIG. 6, the value of the analog input signal having the time series data of the analog input signal of ch4 exceeds the upper limit value of the input conversion range for 500 microseconds due to overshoot. That is, the analog input signal of ch4 is in an over-range state for 500 microseconds due to overshoot.

For example, when the predetermined time is set longer than 500 microseconds, the signal state determination part 131 does not determine the generation of over-range state of the analog input signal caused by overshoot as an abnormal state. Therefore, the controller 40 is not notified of the over-range of the analog input signal caused by overshoot. For example, taking the margin into consideration, the predetermined time may be set to twice the length of the time in which the analog input signal is in an over-range state (1 millisecond in the example shown in FIG. 7(a) and 7(b)).

### §4 Alteration example

The signal processing device 10 may also be capable of performing, for example, an A/D conversion processing in which the resolution is 16 Bit or 18 Bit.

### [Implementation realized by software]

The control block (in particular, the signal state determination part 131, the notification signal generation part 132 and the determination condition setting part 133) of the signal processing device 10 may be realized by a logical circuit (hardware) formed into an integrated circuit (IC chip) or be realized by software.

In the case of the latter, the signal processing device 10 includes a computer for executing commands of programs acting as software which fulfills various functions. The computer includes, for example, more than one processor and computer readable storage medium which stores the programs. Then, the aim of the present invention is achieved by the processor reading the programs from the storage medium and executing the programs in the computer. The processor can be a CPU (Central Processing Unit) for example. Besides "non-temporary tangible medium" such as a ROM (Read Only Memory), the storage medium may also be a tape, a disk, a card, a semiconductor memory, a programmable logical circuit and so on. In addition, a RAM (Random Access Memory) which develops the program may also be included. Besides, the program may be supplied to the computer via any transmission medium (a communication network, a broadcast wave or the like) capable of transmitting the program. Moreover, one aspect of the present invention can also be realized by the form of a data signal which is embedded in a carrier wave and for which the program is embodied by electronic transmission.

### [Description of the Symbols]

1 control system (master-slave control system)
10 signal processing device
14 transmission-reception part (notification part, reception part)
20 sensor
40 controller (control device)
130 upper and lower limit value determination part (display instruction part)
131 signal state determination part
132 notification signal generation part (notification part, display instruction part)
133 determination condition setting part
S3 signal state determination step
S4 notification step

## Claims

1. A signal processing device (10), wherein the signal processing device (10) is configured to process an analog input signal from a sensor (20) and to deliver a notification signal to a control device (40), the signal processing device (10) comprises:
an A/D conversion part (12) configured to convert the analog input signal from the sensor (20) into a digital signal cyclically;
a control part (13), wherein the A/D conversion part (12) is configured to transmit the digital signal to the control part (13);
**characterized in that** the control part (13) comprises:
a signal state determination part (131) configured to determine based on the received digital signal, for the analog input signal, whether an over-range or under-range state lasts longer than a predetermined time; and
a notification part (132) configured to notify the control device (40) that the over-range or under-range state occurs when the signal state determination part (131) determines that the state lasts longer than the predetermined time.

2. The signal processing device (10) according to claim 1, comprising:
a reception part (14) configured to acquire a user operation that sets the predetermined time; and
a determination condition setting part (133) configured to set the predetermined time in accordance with the user operation.

3. The signal processing device (10) according to claim 1 or 2, comprising:
a display instruction part configured to cause time series data of the analog input signal to be displayed on an external machine.

4. The signal processing device (10) according to claim 3, further comprising a plurality of channels (ch1, ch2, ch3, ch4) for connection to each of a plurality of the sensors (20),
wherein the time series data is the time series data of one of the analog input signals input by one of the channels (ch1, ch2, ch3, ch4), or the time series data of a plurality of the analog input signals input by a plurality of different channels.

5. The signal processing device (10) according to any one of claims 1 to 4, wherein
the control device (40) is a master device in a master-slave control system (1), and
the signal processing device (10) is a slave device connectable to the master device via a network.

6. A control method implemented by a signal processing device (10), wherein the signal processing device (10) processes an analog input signal from a sensor (20) and delivers a notification signal to a control device (40), the control method comprises:
an A/D conversion step which converts the analog input signal from the sensor (20) into a digital signal cyclically;
a transmit step which transmits the digital signal from the A/D conversion part (12) to a control part (13);
**characterized by**
in the control part (13), a signal state determination step, which determines based on the received digital signal, for the analog input signal, whether an over-range or under-range state lasts longer than a predetermined time; and
in the control part (13), a notification step, which notifies the control device (40) that the over-range or under-range state occurs when it is determined in the signal state determination step that the state lasts longer than the predetermined time

7. The control method according to claim 6, wherein the predetermined time is an integer multiple of a sampling period of the analog input signal in the signal processing device (10).

## Patentansprüche

1. Signalverarbeitungsvorrichtung (10), wobei die Signalverarbeitungsvorrichtung (10) konfiguriert ist, um ein analoges Eingangssignal von einem Sensor (20) zu verarbeiten und ein Benachrichtigungssignal an eine Steuervorrichtung (40) zu liefern, wobei die Signalverarbeitungsvorrichtung (10) umfasst:
einen A/D-Wandlerteil (12), der so konfiguriert ist, dass er das analoge Eingangssignal von dem Sensor (20) zyklisch in ein digitales Signal umwandelt;
einen Steuerteil (13), wobei der A/D-Wandlerteil (12) so konfiguriert ist, dass er das digitale Signal an den Steuerteil (13) überträgt;
**dadurch gekennzeichnet, dass** der Steuerteil (13) umfasst:
ein Signalzustandsbestimmungsteil (131), das konfiguriert ist, um auf der Grundlage des empfangenen digitalen Signals für das analoge Eingangssignal zu bestimmen, ob ein Über- oder Unterbereichszustand länger als eine vorbestimmte Zeit dauert; und
einen Benachrichtigungsteil (132), der so konfiguriert ist, dass er der Steuervorrichtung (40) mitteilt, dass der Über- oder Unterbereichszustand auftritt, wenn der Signalzustandsbestimmungsteil (131) feststellt, dass der Zustand länger als die vorbestimmte Zeit anhält.

2. Signalverarbeitungsvorrichtung (10) nach Anspruch 1, bestehend aus
ein Empfangsteil (14), das so konfiguriert ist, dass es eine Benutzeroperation erfasst, die die vorbestimmte Zeit einstellt; und
ein Bestimmungsbedingungs-Einstellteil (133), das so konfiguriert ist, dass es die vorbestimmte Zeit in Übereinstimmung mit der Benutzerbedienung einstellt.

3. Signalverarbeitungsvorrichtung (10) nach Anspruch 1 oder 2, bestehend aus
einen Anzeigeanweisungsteil, der so konfiguriert ist, dass er bewirkt, dass Zeitreihendaten des analogen Eingangssignals auf einer externen Maschine angezeigt werden.

4. Signalverarbeitungsvorrichtung (10) nach Anspruch 3, die weiterhin eine Vielzahl von Kanälen (ch1, ch2, ch3, ch4) zur Verbindung mit jedem einer Vielzahl von Sensoren (20) aufweist,
wobei die Zeitreihendaten die Zeitreihendaten eines der analogen Eingangssignale sind, die durch einen der Kanäle (ch1, ch2, ch3, ch4) eingegeben werden, oder die Zeitreihendaten einer Vielzahl der analogen Eingangssignale, die durch eine Vielzahl von verschiedenen Kanälen eingegeben werden.

5. Signalverarbeitungsvorrichtung (10) nach einem der Ansprüche 1 bis 4, wobei die Steuereinrichtung (40) eine Master-Einrichtung in einem Master-Slave-Steuersystem (1) ist, und
die Signalverarbeitungsvorrichtung (10) eine Slave-Vorrichtung ist, die über ein Netzwerk mit der Master-Vorrichtung verbunden werden kann.

6. Durch eine Signalverarbeitungsvorrichtung (10) implementiertes Steuerverfahren, wobei die Signalverarbeitungsvorrichtung (10) ein analoges Eingangssignal von einem Sensor (20) verarbeitet und ein Benachrichtigungssignal an eine Steuervorrichtung (40) liefert, wobei das Steuerverfahren umfasst:
einen A/D-Wandlungsschritt, der das analoge Eingangssignal vom Sensor (20) zyklisch in ein digitales Signal umwandelt;
einen Übertragungsschritt, der das digitale Signal vom A/D-Wandlerteil (12) zu einem Steuerteil (13) überträgt;
**gekennzeichnet durch**
in dem Steuerteil (13), einen Signalzustandsbestimmungsschritt, der auf der Grundlage des empfangenen digitalen Signals für das analoge Eingangssignal bestimmt, ob ein Überbereichs- oder Unterbereichszustand länger als eine vorbestimmte Zeit dauert; und
in dem Steuerteil (13), einen Benachrichtigungsschritt, der die Steuervorrichtung (40) benachrichtigt, dass der Über- oder Unterbereichszustand auftritt, wenn in dem Signalzustandsbestimmungsschritt bestimmt wird, dass der Zustand länger als die vorbestimmte Zeit dauert.

7. Steuerverfahren nach Anspruch 6, wobei die vorbestimmte Zeit ein ganzzahliges Vielfaches einer Abtastperiode der analogen Eingangssignale in der Signalverarbeitungsvorrichtung (10) ist.

## Revendications

1. Dispositif de traitement de signal (10), dans lequel le dispositif de traitement de signal (10) est configuré pour traiter un signal d'entrée analogique en provenance d'un capteur (20) et pour délivrer un signal de notification à un dispositif de commande (40), le dispositif de traitement de signal (10) comprenant :
une partie de conversion analogique/numérique, A/N, (12) configurée pour convertir le signal d'entrée analogique en provenance du capteur (20) en un signal numérique de manière cyclique ;
une partie de commande (13), la partie de conversion A/N (12) étant configurée pour transmettre le signal numérique à la partie de commande (13) ;
**caractérisé par le fait que** la partie de commande (13) comprend :
une partie de détermination d'état de signal (131) configurée pour déterminer sur la base du signal numérique reçu, pour le signal d'entrée analogique, si un état de dépassement au-dessus d'une plage ou de dépassement en-dessous d'une plage dure plus longtemps qu'un temps prédéterminé ; et
une partie de notification (132) configurée pour notifier au dispositif de commande (40) que l'état de dépassement au-dessus d'une plage ou de dépassement en-dessous d'une plage se produit lorsque la partie de détermination d'état de signal (131) détermine que l'état dure plus longtemps que le temps prédéterminé.

2. Dispositif de traitement de signal (10) selon la revendication 1, comprenant :
une partie de réception (14) configurée pour acquérir une opération d'utilisateur qui règle le temps prédéterminé ; et
une partie de réglage de condition de détermination (133) configurée pour régler le temps prédéterminé selon l'opération d'utilisateur.

3. Dispositif de traitement de signal (10) selon la revendication 1 ou 2, comprenant :
une partie d'instruction d'affichage configurée pour amener des données de série chronologique du signal d'entrée analogique à être affichées sur une machine externe.

4. Dispositif de traitement de signal (10) selon la revendication 3, comprenant en outre une pluralité de canaux (ch1, ch2, ch3, ch4) pour une connexion à chacun d'une pluralité des capteurs (20),
dans lequel les données de série chronologique sont les données de série chronologique de l'un des signaux d'entrée analogiques entrés par l'un des canaux (ch1, ch2, ch3, ch4), ou les données de série chronologique d'une pluralité des signaux d'entrée analogiques entrés par une pluralité de canaux différents.

5. Dispositif de traitement de signal (10) selon l'une quelconque des revendications 1 à 4, dans lequel le dispositif de commande (40) est un dispositif maître dans un système de commande maître-esclave (1), et le dispositif de traitement de signal (10) est un dispositif esclave apte à être connecté au dispositif maître par l'intermédiaire d'un réseau.

6. Procédé de commande mis en œuvre par un dispositif de traitement de signal (10), dans lequel le dispositif de traitement de signal (10) traite un signal d'entrée analogique en provenance d'un capteur (20) et délivre un signal de notification à un dispositif de commande (40), le procédé de commande comprenant :
une étape de conversion analogique/numérique, A/N, qui convertit le signal d'entrée analogique en provenance du capteur (20) en un signal numérique de manière cyclique ;
une étape de transmission qui transmet le signal numérique provenant de la partie de conversion A/N (12) à une partie de commande (13) ;
**caractérisé par**
dans la partie de commande (13), une étape de détermination d'état de signal, qui détermine sur la base du signal numérique reçu, pour le signal d'entrée analogique, si un état de dépassement au-dessus d'une plage ou de dépassement en-dessous d'une plage dure plus longtemps qu'un temps prédéterminé ; et
dans la partie de commande (13), une étape de notification, qui notifie au dispositif de commande (40) que l'état de dépassement au-dessus d'une plage ou de dépassement en-dessous d'une plage se produit lorsqu'il est déterminé dans l'étape de détermination d'état de signal que l'état dure plus longtemps que le temps prédéterminé.

7. Procédé de commande selon la revendication 6, dans lequel le temps prédéterminé est un multiple entier d'une période d'échantillonnage du signal d'entrée analogique dans le dispositif de traitement de signal (10).
